# EUROPEAN PATENT APPLICATION

(11) **EP 2 333 844 A2**
(43) Date of publication of application: **15.06.2011**
(21) Application number: 10192666.5
(22) Date of filing: 26.11.2010
(51) Int. Cl.: H01L 31/18

(54) **Process of Making Thin Film Solar Cell**

(30) Priority: 11.12.2009 US 635767
(71) Applicant: General Electric Company, Schenectady, NY 12345 (US)
(72) Inventor: Korevaar, Bastiaan Arie, Niskayuna, NY 12309 (US)
(74) Representative: Szary, Anne Catherine

(57) **Abstract**

A process for making a component of a thin film solar cell is provided. The process includes steps of making the component in the following sequence: depositing an absorber layer on a transparent substrate, depositing a back-contact layer on the absorber layer and activating the absorber layer. The absorber layer comprises tellurium. A process for making a thin film solar cell is also presented.

## Description

### BACKGROUND

The invention relates generally to the field of photovoltaics or solar cells. In particular, the invention relates to back contacts used in a solar cell device and a solar panel made therefrom.

Solar energy is abundant in many parts of the world year round. Unfortunately, the available solar energy is not generally used efficiently to produce electricity. The cost of conventional solar cells, and electricity generated by these cells, is generally very high. For example, a typical solar cell achieves a conversion efficiency of less than about 20 percent. Moreover, solar cells typically include multiple layers formed on a substrate, and thus solar cell manufacturing typically requires a significant number of processing steps. As a result, the high number of processing steps, layers, interfaces, and complexity increase the amount of time and money required to manufacture these solar cells.

Accordingly, there remains a need for an improved solution to the longstanding problem of inefficient and complicated solar energy conversion devices and methods of manufacture.

**BRIEF DESCRIPTION OF THE INVENTION**

Embodiments of the invention are directed towards a process for making a back contact on a thin film solar cell.

According to one embodiment of the invention, a process for making a component of a thin film solar cell is provided. The process includes steps of making the component in the following sequence: depositing an absorber layer on a transparent substrate, depositing a back-contact layer on the absorber layer and activating the absorber layer. The absorber layer comprises tellurium.

In another embodiment, a process for making a component of a thin film solar cell includes the steps in the following sequence of: depositing an absorber layer on a transparent substrate, depositing a back-contact layer on the absorber layer and performing a cadmium chloride treatment. The absorber layer comprises cadmium telluride. The cadmium chloride treatment is performed for activating the absorber layer.

Another embodiment is a process for making a thin film solar cell. The process includes the steps in the sequence as described here below. First a layer of a transparent conductive oxide is deposited on a transparent substrate. In next step, a window layer is deposited on the transparent conductive oxide layer and an absorber layer is deposited on the window layer in the following step. The absorber layer comprises tellurium. A back contact layer is deposited on the absorber layer in next step. The process includes further step of activating the absorber layer.

In yet another embodiment, a process for making a thin film solar cell is provided. The process includes the steps in the sequence as described here below. First a layer of a transparent conductive oxide is deposited on a transparent substrate. In next step, a cadmium sulfide layer is deposited on the transparent conductive oxide layer and a cadmium telluride absorber layer is deposited on the cadmium sulfide layer in the following step. The process further includes a step of depositing a back contact layer on the cadmium telluride absorber layer and then a step of performing a cadmium chloride treatment. Final step of the process includes depositing a metal contact on the back contact layer.

### DRAWINGS

These and other features, aspects, and advantages of the present invention will become better understood when the following detailed description is read with reference to the accompanying drawings, wherein:

FIG. 1 illustrates a flow diagram of a process to make a component of a thin film solar cell in accordance with some embodiments of the present invention.

FIG. 2 illustrates a flow diagram of a process to make a thin film solar cell in accordance with certain embodiments of the present invention.

### DETAILED DESCRIPTION

Approximating language, as used herein throughout the specification and claims, may be applied to modify any quantitative representation that could permissibly vary without resulting in a change in the basic function to which it is related. Accordingly, a value modified by a term or terms, such as "about", is not limited to the precise value specified. In some instances, the approximating language may correspond to the precision of an instrument for measuring the value.

In the following specification and the claims that follow, the singular forms "a", "an" and "the" include plural referents unless the context clearly dictates otherwise. The terms "comprising," "including," and "having" are intended to be inclusive and mean that there may be additional elements other than the listed elements. Moreover, the use of "top," "bottom," "above," "below," and variations of these terms is made for convenience, but does not require any particular orientation of the components unless otherwise stated. As used herein, the terms "deposited on" or "deposited over" refers to both secured or disposed directly in contact with and indirectly by having intervening layers there between.

As used herein, the terms "may" and "may be" indicate a possibility of an occurrence within a set of circumstances; a possession of a specified property, characteristic or function; and/or qualify another verb by expressing one or more of an ability, capability, or possibility associated with the qualified verb. Accordingly, usage of "may" and "may be" indicates that a modified term is apparently appropriate, capable, or suitable for an indicated capacity, function, or usage, while taking into account that in some circumstances the modified term may sometimes not be appropriate, capable, or suitable. For example, in some circumstances, an event or capacity can be expected, while in other circumstances the event or capacity cannot occur - this distinction is captured by the terms "may" and "may be".

Cadmium telluride (CdTe) based solar cell devices typically demonstrate relatively low power conversion efficiencies, which low power conversion efficiencies may be attributed to a relatively low open circuit voltage (*V*_{oc}). The high work function of CdTe material is one of the major barriers in achieving a good Ohmic contact between the CdTe absorber layer and the back contact. P-type CdTe, typically, has a work function of about 5.5 electron-volt or above, depending on the concentration of the charge carriers or charge carrier density. As used herein the phrase "carrier density" refers to the concentration of the majority charge carriers in a material and holes represent majority charge carriers in p-type CdTe. The average carrier density for a p-type CdTe material varies between 1 x 10¹⁴ and 1 x 10¹⁵ per cubic centimeter. No metal or alloy has such a high work function and hence it becomes difficult for metals and alloys to form a good Ohmic contact with the p-type CdTe. The mismatch of work functions creates a barrier at the junction between a metal or alloy contact and the p-type CdTe layer. This barrier hinders the transportation of a majority of the charge carriers and thus brings down fill factor (FF) of the cell.

Fill factor in the context of solar cell technology is defined as a ratio (usually given as percent) of the actual maximum obtainable power to the theoretical (not actually obtainable) power. This is a key parameter in evaluating the performance of solar cells. Typically, solar cells have fill factor between about 0.7 to about 0.

Typically, two approaches are known in the art to overcome the above discussed contact problem and achieve a good quality Ohmic contact. One approach includes forming a thin layer of a semiconductor material having a higher work function than p-type CdTe, such as for example mercury telluride (HgTe), zinc telluride (ZnTe), copper telluride (CuₓTe), arsenic telluride (As₂Te₃), or antimony telluride (Sb₂Te₃), on the backside of the CdTe absorber layer. Another approach is the formation of a p⁺-layer under a back contact by the reaction or in-diffusion of a dopant material into the CdTe absorber layer. As used herein "p⁺-layer" refers to a highly doped semiconductor layer having the concentration of the p-type charge carriers higher than the concentration of the p-type charge carriers in the absorber layer. Typically, the carrier density of a p⁺ layer is greater than or equal to about 1 x 10¹⁷ per cubic centimeter.

These approaches help in reducing the effect of the above-described barrier between the p-type CdTe layer and the back contact. Thus, the back contact usually includes a primary contact that is typically a p⁺-layer and a secondary contact that is a current carrying conductor or a metal contact. Creating a highly doped layer near the secondary contact with a higher carrier density may help in lowering the contact resistance with the p-type CdTe absorber layer due to a higher population of the majority of charge carriers.

When metals are used as the metal contact, metals are known to diffuse through the p-type CdTe layer, over the lifetime of the device, causing significant degradation. For example, copper (Cu) is typically used as the metal contact and is a well-known source of degradation in CdTe based solar cell devices.

An alternate technology for fabrication of a Ni metal contact on the CdTe absorber layer appears to provide acceptable mechanical and electrical properties. This method involves annealing Ni-P alloy coatings. These coatings diffuse phosphorus into the CdTe absorber layer and increase the carrier density of the CdTe layer. The increased charge carrier density results into reduction of the above described barrier.

In addition to the above issues, surface morphology and grain characteristics of CdTe films are important parameters that affect the performance of CdTe solar cells. For example, the lateral resistivity of CdTe films or layers is usually very large, 10⁵ - 10⁸ Ohm-centimeter due to potential barriers at grain boundaries. It should be noted that the grain boundary barrier height could be changed by modifying the grain size and by diffusing appropriate impurities along the grain boundaries. Thus one of the typical steps in cell fabrication is the treatment of the p-type CdTe absorber layer. This step typically involves exposure to CdCl₂ and oxygen followed by a high temperature annealing, and generally referred as "CdCl₂ treatment." The CdCl₂ treatment incorporates or diffuses chlorine within the p-type CdTe absorber layer and creates acceptor states or holes and thus provides an additional increase in carrier densities. Furthermore, the treatment improves material quality by reducing surface defects, and a corresponding reduction in the lateral resistivity of the p-type CdTe absorber layer. Thus, CdCl₂ treatment modifies the electronic properties by reducing resistivity of the p-type CdTe layer due to the combined effect caused by the creation of additional charge carriers (holes) and the improvement in material quality. It has been found that without proper treatment of the backside of the p-type CdTe absorber layer, the resistance related with a back contact is significant, and the open circuit voltage (Voc) and fill factor of the device is reduced, thus reducing the efficiency of the device.

The CdCl₂ treatment is often followed by an etching or cleaning process to remove an oxide formed during the treatment at the backside of the p-type CdTe absorber layer. The oxide formation may be attributed to exposure to oxygen. This etching typically leaves a tellurium-rich surface that works well with the tellurium containing back contact layer. However, the tellurium-rich surface does not work well with other types of back contacts, for example hydrogenated silicon or Ni-P as discussed above. The etching may further result in the formation of pinholes in the absorber layer because of faster etching of the grain boundaries as compared to the grains.

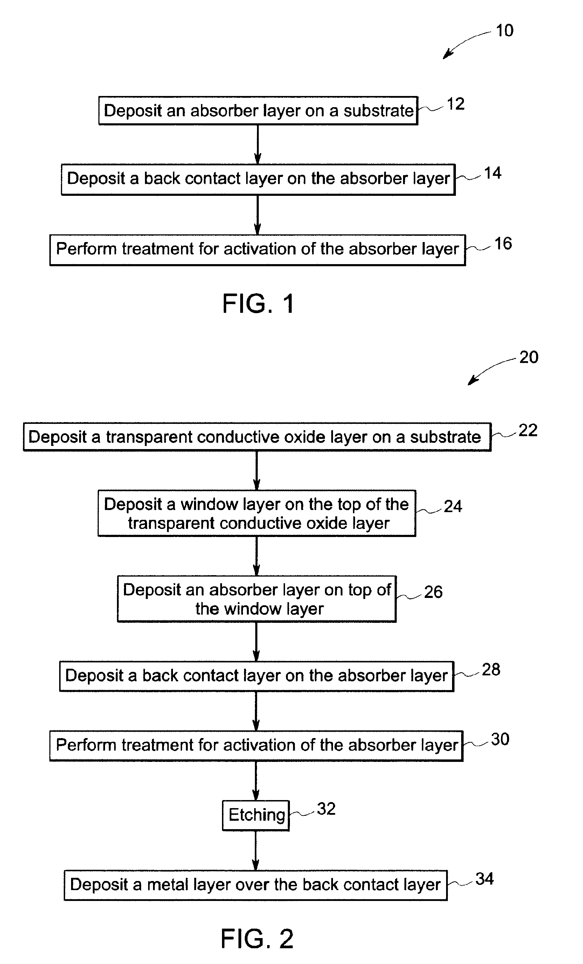

Embodiments of the invention described herein address the noted shortcomings of the state of the art. The process of making a component of of a thin film solar cell includes steps in the sequence as illustrated in flow diagram 10 of FIG. 1, according to one embodiment of the invention. Step 12 deposits an absorber layer on a transparent substrate. Typically, the substrate includes a layer of a transparent conducting layer deposited on the substrate and an n-type window layer deposited on the transparent conducting layer. The absorber layer is deposited on the window layer. The absorber layer is a semiconductor layer including tellurium. In one embodiment, the substrate includes a glass. In another embodiment, the substrate includes a polymer. In step 14, a back contact layer is deposited on the backside of the absorber layer. The method further provides step 16 for activation of the absorber layer.

As used herein, the term "activation of the absorber layer" or "activating the absorber layer" refers to treatment of the absorber layer with a chlorine-containing species (also referred as "chlorine treatment") that improves the absorber layer from nearly intrinsic to p-type by diffusing chlorine within the absorber layer and increasing the carrier density. The activation of the absorber layer further includes a high temperature annealing or heat treatment step following the chlorine treatment. The heat treatment is generally carried out at a temperature in a range from about 350 degrees Celsius to about 500 degrees Celsius. It is also believed that activation treatment improves the material quality of the absorber layer by reducing surface defects, improving the interface between the absorber layer and the n-type window layer, and modifying the grain size depending on prior grain size of the material.

One or more specific embodiments of the present invention will be described below. In an effort to provide a concise description of these embodiments, all features of an actual implementation may not be described in the specification. It should be appreciated that in the development of any such actual implementation, as in any engineering or design project, numerous implementation-specific decisions must be made to achieve the developers' specific goals, such as compliance with system-related and business-related constraints, which may vary from one implementation to another. Moreover, it should be appreciated that such a development effort might be complex and time consuming, but would nevertheless be a routine undertaking of design, fabrication, and manufacture for those of ordinary skill having the benefit of this disclosure.

Typically, when light falls on the thin film solar cell, electrons in the absorber layer are excited from a lower energy "ground state," in which they are bound to specific atoms in the solid, to a higher "excited state," in which they can move through the solid. Since most of the energy in sunlight and artificial light is in the visible range of electromagnetic radiation, a solar cell absorber should be efficient in absorbing radiation at those wavelengths. In one embodiment, the absorber layer comprises a p-type semiconductor. In one embodiment, the absorber layer has a band gap in a range from about 1.3 electron Volts to about 1.7 electron Volts. In another embodiment, the absorber layer has a band gap in a range from about 1.35 electron Volts to about 1.55 electron Volts. In yet another embodiment, the absorber layer has a band gap in a range from about 1.4 electron Volts to about 1.5 electron Volts.

In one embodiment, the absorber layer has a work function in a range from about 5.1 electron Volts to about 5.9 electron Volts. In another embodiment, the absorber layer has a work function in a range from about 5.2 electron Volts to about 5.8 electron Volts. In yet another embodiment, the absorber layer has a work function in a range from about 5.5 electron Volts to about 5.7 electron Volts.

The absorber layer comprises a tellurium-containing p-type semiconductor. In one embodiment, the absorber layer is selected from the group consisting of cadmium telluride, cadmium zinc telluride, tellurium-rich cadmium telluride (i.e., cadmium telluride where the tellurium to cadmium ratio is greater than 1), cadmium sulfur telluride, cadmium manganese telluride, and cadmium magnesium telluride. In one embodiment, the absorber layer comprises cadmium telluride. In another embodiment, the absorber layer comprises p-type cadmium telluride. In some embodiments, the absorber layer is substantially free of silicon.

The back-contact layer is deposited on the absorber layer as shown by step 14 in FIG. 1. In one embodiment, the back-contact layer includes a metal selected from the group consisting of Zn, Cu, Ni, Si, Mo, Mg, Mn, or a combination of two or more thereof. The back-contact layer may include a nitride, a phosphide, an arsenide or an antimonide of the metals. In one embodiment, the back-contact layer includes NiP. In another embodiment, the back-contact layer includes MoN.

In some embodiments, the back-contact layer includes a p⁺-layer. The p⁺-layer comprises silicon and has a higher carrier density when compared to the carrier density of the absorber layer. The p⁺ -layer described herein has a higher carrier density than can be attained in a typical p⁺-type material as currently known in the art. In these embodiments, the absorber layer and the p⁺-layer are compositionally different in that the absorber layer is substantially free of silicon. As used herein, the phrase "substantially free of silicon" refers to a semiconductor material containing up to about 100 parts per million silicon as an impurity. In other words, the phrase "substantially free of silicon" means that silicon is not a main component of the film, though it could occur as a contaminant or a dopant in the absorber layer.

In one embodiment, the p⁺-layer may have a carrier density of holes of greater than about 5x10¹⁷ per cubic centimeter. In another embodiment, the layer may have a carrier density of holes of greater than about 10¹⁸ per cubic centimeter. In yet another embodiment, the layer may have a carrier density of holes of greater than about 2x10¹⁸ per cubic centimeter. The higher the carrier density of the layer, the better is the capability of the layer to minimize the barrier between the back-contact and the absorber layer. In certain embodiments, the p+-layer also has a larger band gap than the absorber layer. In some embodiments, the layer has a higher work function than the absorber layer. Further, in some embodiments the layer has an electron affinity of less than or equal to the electron affinity of the absorber layer.

In one embodiment, the p⁺-layer includes hydrogenated amorphous silicon (a-Si:H), hydrogenated amorphous silicon carbon (a-SiC:H), crystalline silicon (c-Si), hydrogenated microcrystalline silicon (mc-Si:H), hydrogenated amorphous silicon germanium (a-SiGe:H), hydrogenated microcrystalline amorphous silicon germanium (mc a-SiGe:H), gallium arsenide (GaAs), or a combination thereof. In one embodiment, the layer includes a-Si:H or a-SiC:H. This layer can be grown using radio frequency plasma enhanced chemical vapor deposition technique (RF-PECVD). The layer is made with a desirably high carrier concentration by adding either diborane or trimethyl borane (TMB) to the plasma in order to dope the layer with boron. The band gap of the layers may be modified, by adjusting the concentration of boron, germanium, carbon, and/or hydrogen within the layers. One skilled in the art will appreciate the various methods by which such compositional adjustments are generally made.

According to some embodiments of the invention, activation of the absorber layer is performed by treating the solar cell with a chlorine-containing species. The activation step may further include a subsequent heat treatment. In one embodiment, the heat treatment may be carried out at a temperature in a range from about 350 degrees Celsius to about 500 degrees Celsius. In one embodiment, the chlorine-containing species may include a chloride. Suitable examples of chloride include cadmium chloride, stannous chloride, sodium chloride, hydrochloric acid or a combination thereof. In another embodiment, the absorber layer may be treated with a chlorine-containing inert gas. The treatment of the absorber layer is typically carried out in vacuum by using an inert gas containing chlorine. The inert gas may include Chlorofluorocarbons (CFC), Hydrochlofluorocarbons or both.

In a specific embodiment, the absorber layer is activated by cadmium chloride treatment. Various methods may be used to perform cadmium chloride treatment. In one embodiment, the treatment may be carried out by depositing a CdCl₂ film on the back contact layer by simple evaporation. The CdCl₂ film is deposited inhomogeneously and does not fully cover the surface of the back-contact layer. In another embodiment, the absorber layer may be treated with a solution of CdCl₂ salt. For example, the solar cell prepared so far is dipped in a methanol solution containing CdCl₂. In yet another embodiment, the absorber layer may be treated with CdCl₂ vapor by exposing the solar cell in CdCl₂ vapors.

As embodiments of the invention provide activation or treatment of the absorber layer after deposition of the back-contact layer, the back-contact layer has to go through activation/treatment process. As discussed above, the back-contact layer includes materials that survive activation process of the absorber layer and allow chlorine to diffuse through the back-contact layer into the absorber layer.

Some embodiments provide a process of making a thin film solar cell as illustrated in flow diagram of FIG. 2. The process 20 includes steps in the sequence as given in the flow diagram of FIG. 2. A layer of a transparent conductive oxide is deposited on a transparent substrate in step 22. These transparent conductive oxides may be doped or undoped. In an exemplary embodiment, the transparent conductive oxide may include zinc oxide, tin oxide, aluminum doped zinc oxide, fluorine-doped tin oxide, cadmium tin oxide, and zinc tin oxide. In another embodiment, the transparent conductive oxide may include indium-containing oxides. Some examples of suitable indium containing oxides are indium tin oxide (ITO), Ga-In-Sn-O, Zn-In-Sn-O, Ga-In-O, Zn-In-O, and combinations thereof.

Next step 24 of the process 20 provides deposition of a window layer on top of the transparent conductive oxide. In one embodiment, the window layer comprises an n-type semiconductor. Suitable materials for the window layer may include, but are not limited to, Cadmium Sulfide (CdS), Zinc Telluride (ZnTe), Zinc Selenide (ZnSe), Cadmium Selenide (CdSe), Zinc Sulfide (ZnS), Indium Selenide (In₂Se₃), Indium Sulfide (ln₂S₃), Zinc oxihydrate (Zn(OH)), Cadmium Tellurium Sulfide (having tellurium less than about 10 mole percent) and combinations thereof. An absorber layer is deposited on top of the window layer as provided by step 26. The absorber layer is a p-semiconductor layer including tellurium. The n-type window layer and the p-type absorber layer forms a p-n junction required for the solar cell. In an exemplary embodiment, the window layer is an n-type CdS layer and the absorber layer is a p-type CdTe layer.

The process 20 further includes step 28 providing a back-contact layer deposited on top of the absorber layer. The absorber layer is activated in step 30 by performing treatments as discussed in above embodiments.

The process 20 may further include an etching step 32. In one embodiment, the etch may be carried out by using hydrochloric acid. In one embodiment the etching step is performed to remove an oxide formed on the back-contact layer during the treatment of the absorber layer. In another embodiment the etching step is used to remove residuals from the surface, and is more like a washing step than an actual etch. The etching works by removing non-stoichiometric material that forms at the surface during processing. Usually, the treatment of absorber layer with CdCl₂ is followed by the etching step. Other etching techniques known in the art that may result in a stoichiometric cadmium telluride at the interface may also be employed. A metal layer is further deposited on the surface of the back-contact layer to form a back contact in step 34. In one embodiment, the back contact comprises one or more metals selected from molybdenum, aluminum, chromium, and nickel. In certain embodiments, another metal layer for example, aluminum, is disposed on the back contact layer to provide lateral conduction to the outside circuit.

In one embodiment, the layers may be deposited by employing one or more methods selected from close-space sublimation (CSS), vapor transport method (VTM), ion-assisted physical vapor deposition (IAPVD), radio frequency or pulsed magnetron sputtering (RFS or PMS), plasma enhanced chemical vapor deposition (PECVD), and electrochemical bath deposition (ECD).

Thus, the process advantageously provides improved back-contacts with lower contact resistance and better quality of the absorber layer at the interface, and consists of relatively simple processing steps. The process employs other materials for the back-contact layer and does not restrict to tellurides. Moreover, the process of the invention may avoid the formation of pinholes in the absorber layer near the interface during etching as activation of the absorber layer followed by etching is performed after deposition of the back-contact layer over the absorber layer. The back-contact layer protects the surface of the absorber layer and does not allow etching of the absorber layer and formation of pinholes in the layer. As a result, the process of above discussed embodiments enhances/improves the performance and the efficiency of the cell by improving shunt resistance, open circuit voltage and fill factor of the cell.

The above-described process/method of making back-contacts can be very easily exploited for industrial production line. A plurality of solar cells as described above may be assembled in series to form a solar panel.
For completeness, various aspects of the invention are now set out in the following numbered clauses:
1. A process for making a component of a thin film solar cell, the process comprising the steps in the following sequence of:
   depositing an absorber layer comprising tellurium on a transparent substrate;
   depositing a back-contact layer on the absorber layer; and
   activating the absorber layer.
2. The process of clause 1, wherein activating the absorber layer comprises treating the absorber layer with a chlorine ―containing species.
3. The process of clause 2, wherein the chlorine-containing species comprises a chloride selected from the group consisting of cadmium chloride, stannous chloride, sodium chloride, hydrochloric acid or a combination thereof.
4. The process of clause 2, wherein the chlorine -containing species comprises a chlorine-containing inert gas.
5. The process of clause 4, wherein the chlorine-containing inert gas includes Chlorofluorocarbons (CFC), Hydrochlorofluorocarbons or both.
6. The process of clause 1, wherein activating the absorber layer further comprises a high temperature annealing (heat treatment) step.
7. The process of clause 6, wherein the high temperature annealing (heat treatment) is carried out at a temperature in a range from about 350 degrees Celsius to about 500 degrees Celsius.
8. The process of clause 1, further comprises an etching step.
9. The process of clause 1, wherein the transparent substrate comprises a glass or a polymer.
10. The process of clause 1, wherein the absorber layer comprises cadmium telluride, cadmium zinc telluride, cadmium manganese telluride, cadmium sulfur telluride or cadmium magnesium telluride.
11. The process of clause 1, wherein the back contact layer comprises a metal selected from the group consisting of Zn, Cu, Ni, Si, Mg, or a combination thereof.
12. The process of clause 1, wherein the back-contact layer comprises a nitride, a phosphide, an arsenide, or an antimonide.
13. The process of clause 12, wherein the back contact layer comprises NiP or MoN.
14. The process of clause 1, wherein the back contact layer comprises morphous Si:H, amorphous SiC:H, crystalline-Si, microcrystalline-Si:H, microcrystalline-Si, a-SiGe:H, microcrystalline a-SiGe:H, GaAs, or a combination thereof.
15. A process for making a component of a thin film solar cell, the process comprising the steps in the following sequence of:
   depositing an absorber layer comprising cadmium telluride on a transparent substrate;
   depositing a back-contact layer on the absorber layer; and
   performing a cadmium chloride treatment.
16. The process of clause 15, wherein performing the cadmium chloride treatment comprises dipping the component of the thin film solar cell into a solution of cadmium chloride salt.
17. The process of clause 15, wherein performing the cadmium chloride treatment comprises depositing an inhomogeneous cadmium chloride film on the back contact layer.
18. The process of clause 15, wherein performing the cadmium chloride treatment comprises exposing the component of the thin film solar cell in cadmium chloride vapors.
19. A process for making a thin film solar cell, the process comprising the steps in the following sequence of:
   deposing a transparent conductive layer on a transparent substrate;
   deposing a window layer on the transparent conductive layer;
   depositing an absorber layer comprising tellurium on the window layer;
   depositing a back-contact layer on the absorber layer;
   activating the absorber layer, and
   depositing a metal contact on the back contact layer.
20. The process of clause 19, wherein the transparent conductive layer comprises a transparent conductive oxide.
21. The process of clause 19, wherein the window layer comprises cadmium sulfide, zinc sulfide, cadmium tellurium sulfide, or a combination thereof.
22. The process of clause 19, wherein activating the absorber layer comprises treating the absorber layer with a chlorine ―containing species.
23. The process of clause 19, wherein activating the absorber layer further comprises a high temperature annealing.
24. The process of clause 19, further comprses an etching or cleaning step after activating the absorber layer.
25. A process for making a thin film solar cell, the process comprising the steps in the following sequence of:
   deposing a transparent conductive oxide layer on a transparent substrate;
   deposing a cadmium sulfide (CdS) layer on the transparent conductive oxide layer;
   depositing a cadmium telluride (CdTe) absorber layer on the CdS layer;
   depositing a back-contact layer on the CdTe absorber layer;
   performing a cadmium chloride treatment, and
   depositing a metal contact on the back contact layer.

## Claims

1. A process for making a component of a thin film solar cell, the process comprising the steps in the following sequence of:
depositing an absorber layer comprising tellurium on a transparent substrate;
depositing a back-contact layer on the absorber layer; and
activating the absorber layer.

2. The process of claim 1, wherein activating the absorber layer comprises treating the absorber layer with a chlorine-containing species.

3. The process of claim 2, wherein the chlorine-containing species comprises a chloride selected from the group consisting of cadmium chloride, stannous chloride, sodium chloride, hydrochloric acid or a combination thereof.

4. The process of claim 2, wherein the chlorine-containing species comprises a chlorine-containing inert gas.

5. The process of claim 4, wherein the chlorine-containing inert gas includes Chlorofluorocarbons (CFC), Hydrochlorofluorocarbons or both.

6. The process of any preceding claim, wherein activating the absorber layer further comprises a high temperature annealing (heat treatment) step.

7. The process of claim 6, wherein the high temperature annealing (heat treatment) is carried out at a temperature in a range from about 350 degrees Celsius to about 500 degrees Celsius.

8. The process of any preceding claim, further comprises an etching step.

9. The process of any preceding claim, wherein the transparent substrate comprises a glass or a polymer.

10. The process of any preceding claim, wherein the absorber layer comprises cadmium telluride, cadmium zinc telluride, cadmium manganese telluride, cadmium sulfur telluride or cadmium magnesium telluride.

11. The process of any preceding claim, wherein the back contact layer comprises a metal selected from the group consisting of Zn, Cu, Ni, Si, Mg, or a combination thereof.

12. The process of any one of claims 1 to 10, wherein the back contact layer comprises amorphous Si:H, amorphous SiC:H, crystalline-Si, microcrystalline-Si:H, microcrystalline-Si, a-SiGe:H, microcrystalline a-SiGe:H, GaAs, or a combination thereof.

13. The process of any preceding claim, the process comprising the steps in the following sequence of:
depositing an absorber layer comprising cadmium telluride on a transparent substrate;
depositing a back-contact layer on the absorber layer; and
performing a cadmium chloride treatment.

14. A process for making a thin film solar cell, the process comprising the steps in the following sequence of:
deposing a transparent conductive layer on a transparent substrate;
deposing a window layer on the transparent conductive layer;
depositing an absorber layer comprising tellurium on the window layer;
depositing a back-contact layer on the absorber layer;
activating the absorber layer, and
depositing a metal contact on the back contact layer.

15. The process of claim 14 for making a thin film solar cell, the process comprising the steps in the following sequence of:
deposing a transparent conductive oxide layer on a transparent substrate;
deposing a cadmium sulfide (CdS) layer on the transparent conductive oxide layer;
depositing a cadmium telluride (CdTe) absorber layer on the CdS layer;
depositing a back-contact layer on the CdTe absorber layer;
performing a cadmium chloride treatment, and
depositing a metal contact on the back contact layer.
